# EUROPÄISCHE PATENTSCHRIFT

(11) **EP 4 070 363 B1**
(45) Veröffentlichungstag und Bekanntmachung des Hinweises auf die Patenterteilung: **15.05.2024**
(21) Anmeldenummer: 20803488.4
(22) Anmeldetag: 05.11.2020
(51) Int. Cl.: H01L 21/28, H01L 21/268

(54) **VERFAHREN ZUM BILDEN EINES ELEKTRISCHEN KONTAKTS UND VERFAHREN ZUM BILDEN EINER HALBLEITERVORRICHTUNG**
METHOD FOR FORMING AN ELECTRICAL CONTACT AND METHOD FOR FORMING A SEMICONDUCTOR DEVICE
PROCÉDÉ DE FORMATION DE CONTACT ÉLECTRIQUE ET PROCÉDÉ DE FORMATION D'UN DISPOSITIF À SEMI-CONDUCTEURS

(30) Priorität: 03.12.2019 DE 102019218725
(43) Veröffentlichungstag der Anmeldung: 12.10.2022
(73) Patentinhaber: Robert Bosch GmbH, 70442 Stuttgart (DE)
(72) Erfinder: RODRIGUEZ ALVAREZ, Humberto, 70806 Kornwestheim (DE); ALSMEIER, Jan-Hendrik, 72793 Pfullingen (DE)
(86) Internationale Anmeldenummer: PCT/EP2020/081084
(87) Internationale Veröffentlichungsnummer: WO 2021/110348

(56) Entgegenhaltungen:
- EP-A1- 3 131 112

## Beschreibung

Die Erfindung betrifft ein Verfahren zum Bilden eines elektrischen Kontakts und ein Verfahren zum Bilden einer Halbleitervorrichtung.

Siliziumcarbid ist ein insbesondere in den letzten Jahren zunehmend in der Halbleiterindustrie verwendetes Halbleitermaterial.

In der US 8,216,929 B2 ist ein Verfahren zum Bilden eines elektrischen Kontakts (einer Halbleitervorrichtung) auf einem Siliziumcarbidsubstrat offenbart, bei welchem zunächst eine Oberfläche des Siliziumcarbidsubstrats so bearbeitet wird, dass ihr Mittenrauwert kleiner als 10 nm ist. Daraufhin wird die Oberfläche mittels eines Plasmas beschädigt, woraufhin in einem nachfolgenden Prozess eine dünne Metallschicht auf die beschädigte Oberfläche aufgebracht wird. Abschließend wird die dünne Metallschicht mit Laserlicht bestrahlt.

EP 3131112 A1 offenbart ein Verfahren zum Bilden eines elektrischen Kontakts auf einem Siliziumcarbidsubstrat.

Eine der Erfindung zugrundeliegende Aufgabe kann darin gesehen werden, ein Verfahren zum Bilden eines elektrischen Kontakts auf einer Siliziumcarbidoberfläche mit einer verringerten Anzahl an Prozessschritten bereitzustellen.

In verschiedenen Ausführungsbeispielen wird ein Verfahren zum Bilden eines elektrischen Kontakts bereitgestellt. Das Verfahren kann ein Schleifen einer Siliziumcarbidoberfläche mit einem Schleifteller, der eine Schleiffläche aufweist, welche Nickel oder eine Nickelverbindung enthält, aufweisen. Dabei kann das Schleifen derart erfolgen, dass Partikel des Nickels oder der Nickelverbindung aus dem Schleifteller in der geschliffenen Siliziumcarbidoberfläche eingelagert werden. Das Verfahren kann ferner ein Tempern der geschliffenen Siliziumcarbidoberfläche mittels eines Lasers aufweisen, welches derart erfolgen kann, dass zumindest ein Teil der eingelagerten Nickelpartikel mit Silizium des Siliziumcarbids ein Nickelsilizid bildet.

In verschiedenen Ausführungsbeispielen kann das beschriebene Verfahren genutzt werden, um eine Siliziumcarbid-Halbleitervorrichtung zu bilden, z.B. einen Transistor, z.B. einen MOSFET, z.B. einen Leistungs-MOSFET.

Das oben beschriebene Verfahren kann ein Bilden eines ohmschen Kontakts auf einem Siliziumcarbid (SiC)-Substrat ermöglichen. Der elektrische (ohmsche) Kontakt kann zwischen dem Siliziumcarbid und dem Nickelsilizid gebildet werden.

In verschiedenen Ausführungsbeispielen können ein Beschädigen/Aufrauen der Siliziumcarbidoberfläche und ein Anordnen von Metall auf bzw. in der beschädigten/aufgerauten Oberfläche in einem Prozess vereint werden. Dabei kann ein Schleifgerät, welches zum Bearbeiten der Oberfläche verwendet wird, so gestaltet sein, dass es beim Bearbeiten der Siliziumcarbidoberfläche Metallpartikel abgibt, welche in der beschädigten/aufgerauten Oberfläche eingelagert werden.

Im Folgenden wird für das Schleifgerät der Begriff "Schleifteller" verwendet. Es ist jedoch zu verstehen, dass das Schleifgerät eine andere als die häufig verwendete Tellerform aufweisen kann. Das Schleifgerät kann beispielsweise ein Schleifrad, bandförmig oder zylindrisch sein, oder eine andere geeignete Form aufweisen.

In verschiedenen Ausführungsbeispielen wird ein Herstellungsverfahren für einen elektrischen Kontakt auf Siliziumcarbid bereitgestellt, bei dem darauf verzichtet werden kann, zwei getrennte Prozesse für ein Vorbereiten einer Oberfläche einerseits und ein Ab-/ bzw. Einlagern von Metall in die Oberfläche andererseits vorzusehen.

Ein Kombinieren des Aufrauens/Beschädigens der Oberfläche mit dem Einlagern des Nickels in die Oberfläche, anders ausgedrückt ein Verzichten auf einen separaten Ablagerungsprozess für das Metall, kann bedeuten, dass Herstellungskosten zum Bilden der elektrisch leitenden Verbindung reduziert sind bzw. werden.

Eine Herstellung einer elektrisch leitenden Verbindung kann in verschiedenen Ausführungsbeispielen dahingehend vereinfacht sein, dass ein Schleifen einer Siliziumcarbidoberfläche mit einem nickelhaltigen Schleifteller und ein Lasertempern ausreichend sein können, um die elektrisch leitende Verbindung zum Siliziumcarbid zu bilden.

Das Schleifen kann derart erfolgen, dass das Siliziumcarbidsubstrat auf eine Dicke von etwa 50 µm bis 200 µm gedünnt wird, wobei die geschliffene Oberfläche einen Mittenrauwert von mehr als 10 nm aufweisen kann und sich unterhalb der geschliffenen Oberfläche bis zu einer Tiefe von mindestens etwa 10 nm und höchstens etwa 500 nm Kristalldefekte und mittels des Schleiftellers eingebrachte Nickelpartikel befinden können.

Ferner kann das Tempern derart ausgeführt werden, dass die Kristalldefekte in der Schicht unter der Oberfläche reduziert werden, dass zumindest Teile des eingelagerten Nickels mit dem Silizium des Siliziumcarbids (z.B. zu Nickelsilizid) reagieren und ein ohmscher Kontakt mit einem Kontaktwiderstand von weniger als 1 mΩcm² gebildet wird.

Weiterbildungen der Aspekte sind in den Unteransprüchen und der Beschreibung dargelegt. Ausführungsformen der Erfindung sind in den Figuren dargestellt und in der nachfolgenden Beschreibung näher erläutert. Es zeigen:
- Figur 1A bis 1C: eine schematische Veranschaulichung eines Verfahrens zum Bilden eines elektrischen Kontakts gemäß verschiedenen Ausführungsbeispielen;
- Figur 2: ein Ablaufdiagramm eines Verfahrens zum Bilden eines elektrischen Kontakts gemäß verschiedenen Ausführungsbeispielen; und
- Figur 3: ein Ablaufdiagramm eines Verfahrens zum Bilden einer Halbleitervorrichtung gemäß verschiedenen Ausführungsbeispielen, und
- Figur 4: eine Halbleitervorrichtung, die mittels eines Verfahrens zum Bilden einer Halbleitervorrichtung gemäß verschiedenen Ausführungsbeispielen hergestellt wurde.

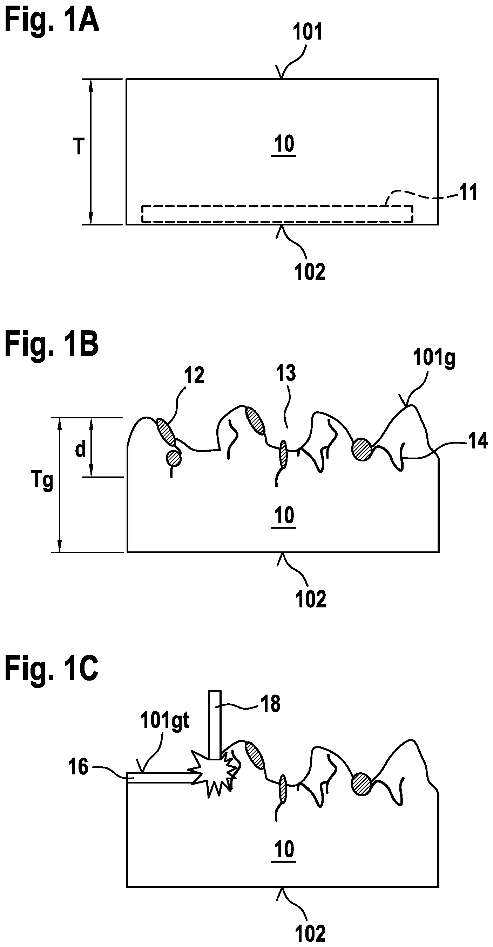

FIG. 1A bis 1C zeigen eine schematische Veranschaulichung eines Verfahrens zum Bilden eines elektrischen Kontakts 16 gemäß verschiedenen Ausführungsbeispielen.

FIG. 1A zeigt ein Siliziumcarbidsubstrat (kurz: Substrat) 10 mit einer Oberfläche 101. Das Siliziumcarbidsubstrat 10 kann beispielsweise ein SiC-Wafer sein. Das Substrat 10 kann eine Dicke T aufweisen, z.B. eine Dicke zwischen etwa 250 µm und etwa 430 µm oder mehr. Die Oberfläche 101 kann eine erste Hauptoberfläche 101 des Siliziumcarbidsubstrats 10 sein. Das Silizumcarbidsubstrat 10 kann eine der ersten Hauptoberfläche 101 gegenüberliegende zweite Hauptoberfläche102 aufweisen. Im Folgenden wird das Bilden des elektrischen Kontakts 16 an der gesamten Oberfläche 101 beschrieben. In verschiedenen Ausführungsbeispielen kann das Bilden des elektrischen Kontakts 16 auf einem Teilbereich oder mehreren miteinander verbundenen oder voneinander getrennten Teilbereichen der Oberfläche 101 erfolgen. In verschiedenen Ausführungsbeispielen kann das Bilden des elektrischen Kontakts 16 alternativ oder zusätzlich auf der zweiten Hauptoberfläche 102 erfolgen, z.B. auf der gesamten zweiten Hauptoberfläche 102 oder auf einem Teilbereich oder mehreren miteinander verbundenen oder voneinander getrennten Teilbereichen der zweiten Hauptoberfläche 102.

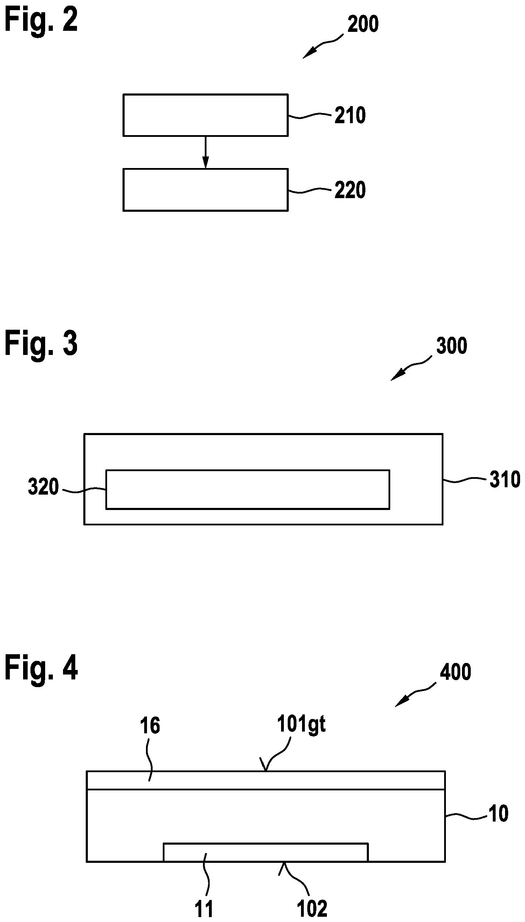

In dem Substrat 10 kann gemäß verschiedenen Ausführungsbeispielen ein elektronisches Halbleiterbauelement 11 gebildet sein (in FIG. 1A schemenhaft angedeutet; siehe auch FIG. 4). Das Halbleiterbauelement 11 kann beispielsweise als ein vertikales Bauelement so in dem Substrat 10 gebildet sein, dass es sich von der zweiten Hauptoberfläche 102 aus in das Substrat 10 hinein erstreckt zu einer an der ersten Hauptoberfläche 101 auszubildenden Elektrode. Beispielsweise kann das elektronische Halbleiterbauelement 11 ein vertikaler Transistor sein, und der elektrische Kontakt 16 auf der ersten Hauptoberfläche 101 kann eine Drainelektrode oder eine Kontaktschicht für eine Drainelektrode sein. Der Transistor kann beispielsweise ein (Leistungs-)MOSFET sein, oder ein anderes geeignetes vertikales Bauelement. In verschiedenen Ausführungsbeispielen kann das Verfahren zum Bilden eines elektrischen Kontakts 16 verwendet werden, um mindestens einen elektrischen Kontakt 16, z.B. mindestens eine Elektrode, für ein laterales elektronisches Halbleiterbauelement zu bilden.

FIG. 1B zeigt das Substrat 10, nachdem seine Oberfläche 101 geschliffen wurde. Dementsprechend ist die geschliffene Oberfläche mit dem Bezugszeichen 101g versehen.

Mittels des Schleifens kann die Dicke T des Substrats 10 verringert werden auf die gedünnte Dicke Tg. Das Schleifen kann in verschiedenen Ausführungsbeispielen im Wesentlichen einen zum Dünnen des Substrats 10 ohnehin typischerweise vorgenommenen Schleifvorgang aufweisen. Dabei kann das Siliziumcarbidsubstrat 10 auf eine gedünnte Dicke Tg von etwa 50 µm bis etwa 200 µm gedünnt werden. In verschiedenen Ausführungsbeispielen kann das Schleifen ein Vorgang sein, der dem Bilden des elektrischen Kontakts 16 dient, beispielsweise in einem Fall, dass der elektrische Kontakt 16 an derjenigen Hauptoberfläche 101 oder 102 gebildet wird, die das elektronische Bauelement aufweist.

Das Schleifen kann mittels eines Schleiftellers oder eines sonstigen geeigneten Schleifgeräts erfolgen. Der Schleifteller kann in seiner Schleiffläche Nickel und/oder eine Nickelverbindung, z.B. eine Nickellegierung, aufweisen. Ein Nickelgehalt des Schleiftellers kann zwischen etwa 0,1 Gew.% und 100 Gew.% liegen. Anders ausgedrückt kann der Schleifteller vollständig oder nur teilweise aus Nickel bestehen. Der nur teilweise aus Nickel bestehende Schleifteller kann beispielsweise ferner ein Glas- oder Keramikmaterial aufweisen, z.B. SiO₂, ZnO und/oder CaO. Das Nickel kann in das Glas- bzw. Keramikmaterial eingebettet sein, z.B. als Nickelpartikel.

Die nickelhaltige Schleiffläche kann so gestaltet sein, z.B. hinsichtlich ihrer Rauheit, dass mittels des Schleifens die Oberfläche 101 aufgeraut und eine Kristallstruktur des Siliziumcarbids beschädigt wird. Ferner können Nickelpartikel 12 während des Schleifens in die Oberfläche 101 bzw. 101g eingebracht werden. Anders ausgedrückt können mittels des Schleifens in der Oberfläche 101g Vertiefungen 13 und Kristallgitterschäden 14 (z.B. Mikrorisse, Verschiebungen und/oder Poren) gebildet werden und ferner die Nickelpartikel 12 auf und/oder in die Oberfläche 101g des Substrats 10 eingebracht werden. Die Nickelpartikel 12 können beispielsweise in den Vertiefungen 13 und an Stellen angeordnet sein, an welchen die Kristallgitterschäden 14 vorliegen. Das Schleifen kann derart erfolgen, dass die Vertiefungen 13, die Kristallgitterschäden 14 und die Nickelpartikel 12 sich bis zu einer Tiefe d von etwa 10 nm bis etwa 500 nm in das Substrat 10 hinein erstrecken. Der oberflächennahe Bereich, in welchem die Kristallgitterschäden 14, die Vertiefungen 13 und das eingelagerte Nickel 12 vorliegen, wird auch als Schädigungsbereich bezeichnet.

Um eine vorbestimmte Tiefe des Schädigungsbereichs und eine gewünschte Menge darin eingelagerten Nickels 12 zu erreichen, können Parameter, die den Schleifvorgang betreffen, angepasst werden, z.B. der Nickelgehalt und die Rauheit des Schleiftellers, die Schleifdauer, ein Anpressdruck während des Schleifvorgangs, usw. In verschiedenen Ausführungsbeispielen kann eine größere Tiefe des Schädigungsbereichs (z.B. zwischen 200 nm und 500 nm) beispielsweise angestrebt sein, wenn vorgesehen ist, den gebildeten elektrischen Kontakt 16 direkt als Elektrode zu nutzen, und/oder wenn der elektrische Kontakt 16 die Rückseitenelektrode des Halbleiterbauteils bildet. Umgekehrt kann eine geringere Tiefe (z.B. zwischen 10 nm und 200 nm) des Schädigungsbereichs angestrebt sein, wenn vorgesehen ist, dass der gebildete elektrische Kontakt 16 lediglich als eine Saatschicht zum Ablagern einer weiteren elektrisch leitfähigen Schicht dient, und/oder wenn der elektrische Kontakt 16 mindestens eine Vorderseitenelektrode bildet.

Ein Mittenrauwert Ra der geschliffenen Oberfläche 101g kann zwischen etwa 10 nm und etwa 500 nm betragen, beispielsweise zwischen etwa 10 nm und etwa 50 nm.

In verschiedenen Ausführungsbeispielen kann das Substrat 10 nach dem Schleifen alle oben beschriebenen Eigenschaften gleichzeitig aufweisen, also eine Dicke Tg des Substrats 10 von etwa 50 µm < Tg < 200 µm, einen Mittenrauwert Ra von etwa 10 nm < Ra < 500 nm und einen Schädigungsbereich mit einer Dicke zwischen etwa 10 nm und etwa 500 nm, und Nickel und/oder Nickelverbindungen 12, die an der geschliffenen Oberfläche 101g und/oder im Schädigungsbereich angeordnet sind.

In FIG. 1C ist das Siliziumcarbidsubstrat 10 mit der geschliffenen Oberfläche 101g während eines Tempervorgangs dargestellt. Das Tempern kann mittels eines Lasers erfolgen, dessen Laserlicht 18 auf die geschliffene Oberfläche 101g gestrahlt wird. Das Bestrahlen mittels des Laserlichts 18 - das Tempern - kann so ausgeführt werden, dass die Defekte (die Vertiefungen 13 und die Kristallgitterschäden 14) verringert bzw. vermindert werden, dass zumindest ein Teil des Nickels bzw. der Nickelverbindungen 12 mit dem Silizium des Siliziumkarbidsubstrats 10 reagiert (z.B. zu Nickelsilizid), und dass ein ohmscher Kontakt 16 an der Oberfläche 101g gebildet wird, wobei der Kontakt 16 einen Kontaktwiderstand von weniger als 1 mΩcm² aufweisen kann. Die nach dem Tempern erhaltene Oberfläche mit dem ohmschen Kontakt 16 ist in FIG. 1C mit dem Bezugszeichen 101gt gekennzeichnet.

In FIG. 1C ist auf der linken Seite dargestellt, dass nach dem Bestrahlen der geschliffenen Oberfläche 101g mit dem Laserlicht 18 die Defekte vermindert bzw. beseitigt sein können. Das Laserlicht 18 kann in verschiedenen Ausführungsbeispielen eine Wellenlänge von weniger als 400 nm aufweisen, und eine Energiedichte von mehr als 2 J cm⁻².

Während des Lasertemperns kann eine Rekristallisierung stattfinden. Diese kann zu einer Änderung (Verringerung) der Oberflächenrauheit führen. Beispielsweise kann der Mittenrauwert Ra nach dem Tempern weniger als die Hälfte des Mittenrauwerts Ra vor dem Tempern betragen.

Das Lasertempern kann ferner dazu führen, dass das in der oberflächennahen Schicht vorhandene Nickel 12 eine chemische Verbindung mit dem Silizium eingeht (und z.B. Nickelsilizid bildet), und dass ferner ein Teil des Siliziums verdampft. Die durch das Lasertempern gebildete Nickelsilizid-Verbindung kann eine elektrisch leitende Schicht und damit die elektrische Verbindung (den Kontakt) 16 bilden. Eine Dicke der elektrisch leitenden Verbindung 16 kann in einem Bereich von etwa 10 nm bis etwa 500 nm liegen, beispielsweise zwischen etwa 10 nm und etwa 50 nm.

Sofern die elektrische Verbindung, wie oben beschrieben, nur auf einem Teilbereich der Oberfläche des Substrats 10 gebildet wird, kann das erreicht werden, indem nur der Teilbereich der Oberfläche 101 geschliffen und anschließend mit dem Laserlicht 18 bestrahlt wird, und/oder indem zwar die gesamte Oberfläche 101 geschliffen wird, das Tempern jedoch nur auf dem Teilbereich der Oberfläche 101 ausgeführt wird. Sofern die gesamte Oberfläche 101 geschliffen wurde, aber nur in einem Teilbereich der Oberfläche 101 die elektrische Verbindung gebildet wird/wurde, kann auf dem geschliffenen, unbestrahlten Bereich eine Schutzschicht angeordnet werden (nicht dargestellt).

In verschiedenen Ausführungsbeispielen kann der elektrisch leitende Kontakt 16 direkt die Elektrode des elektronischen Halbleiterbauteils bilden. In verschiedenen Ausführungsbeispielen kann der elektrisch leitende Kontakt 16 eine unterste Schicht eines die Elektrode bildenden Schichtstapels sein. Anders ausgedrückt kann der elektrisch leitende Kontakt 16 als Grund- oder Saatschicht zum (z.B. galvanischen) Aufbringen mindestens einer weiteren elektrisch leitenden Schicht genutzt werden.

FIG. 2 zeigt ein Ablaufdiagramm eines Verfahrens 200 zum Bilden eines elektrischen Kontakts gemäß verschiedenen Ausführungsbeispielen.

Das Verfahren kann ein Schleifen einer Siliziumcarbidoberfläche mit einem Schleifteller, der eine Schleiffläche aufweist, welche Nickel oder eine Nickelverbindung enthält, aufweisen, derart, dass Partikel des Nickels oder der Nickelverbindung aus dem Schleifteller in der geschliffenen Siliziumcarbidoberfläche eingelagert werden (210), und ein Tempern der geschliffenen Siliziumcarbidoberfläche mittels eines Lasers, derart, dass zumindest ein Teil der eingelagerten Nickelpartikel mit Silizium des Siliziumcarbids ein Nickelsilizid bildet (220).

FIG. 3 zeigt ein Ablaufdiagramm eines Verfahrens 300 zum Bilden einer Halbleitervorrichtung gemäß verschiedenen Ausführungsbeispielen.

Das Verfahren kann ein Bilden eines Halbleiterbauelements in einem Siliziumcarbidsubstrat aufweisen (310), wobei ein Bilden einer Elektrode des Halbleiterbauelements das Verfahren zum Bilden eines elektrischen Kontakts gemäß einem der obigen Ausführungsbeispiele aufweist (320).

Das Verfahren kann auf Waferebene ausgeführt werden. Das gilt ebenfalls für das Verfahren zum Bilden des elektrischen Kontakts gemäß verschiedenen Ausführungsbeispielen.

Das Halbleiterbauelement kann in verschiedenen Ausführungsbeispielen ein Transistor sein.

FIG. 4 zeigt eine Halbleitervorrichtung 400, die mittels eines Verfahrens zum Bilden einer Halbleitervorrichtung gemäß verschiedenen Ausführungsbeispielen, beispielsweise wie oben ausführlich dargestellt, hergestellt wurde.

Die Halbleitervorrichtung 400weist ein Siliziumcarbidsubstrat 10 mit einem darauf gebildeten elektrischen Kontakt 16 auf, welcher eine Oberfläche 101gt der Halbleitervorrichtung 400 bildet.

Die Halbleitervorrichtung 400 weist ferner ein im Substrat 10 gebildetes Halbleiterbauelement 11 auf, welches sich beispielhaft von einer zweiten Oberfläche 102 in das Substrat 10 hinein erstreckt. Der elektrische Kontakt 16 kann beispielsweise eine Rückseitenelektrode des Halbleiterbauelements 11 sein.

## Patentansprüche

1. Verfahren zum Bilden eines elektrischen Kontakts (16), aufweisend:
• Schleifen einer Siliziumcarbidoberfläche (101) mit einem Schleifteller, der eine Schleiffläche aufweist, welche Nickel oder eine Nickelverbindung enthält, derart, dass Partikel (12) des Nickels oder der Nickelverbindung aus dem Schleifteller in der geschliffenen Siliziumcarbidoberfläche eingelagert werden (210); und
• Tempern der geschliffenen Siliziumcarbidoberfläche (101g) mittels eines Lasers, derart, dass zumindest ein Teil der eingelagerten Nickelpartikel (12) mit Silizium des Siliziumcarbids ein Nickelsilizid bildet (220)

2. Verfahren gemäß Anspruch 1,
wobei das Nickelsilizid eine Oberflächenschicht (101gt) bildet, die optional einen Mittenrauwert von 10 nm < Ra < 500 nm aufweist.

3. Verfahren gemäß Anspruch 1 oder 2,
wobei das Schleifen der Siliziumcarbidoberfläche ein Dünnen eines Siliziumcarbidsubstrats (10) auf eine Dicke zwischen 50 µm und 200 µm aufweist.

4. Verfahren gemäß einem der Ansprüche 1 bis 3,
wobei die geschliffene Siliziumcarbidoberfläche (101g) einen Mittenrauwert Ra von 10 nm < Ra < 500 nm aufweist.

5. Verfahren gemäß einem der Ansprüche 1 bis 4,
wobei der Schleifteller zwischen 0,1 Gew.% und 100 Gew.% Nickel enthält.

6. Verfahren gemäß einem der Ansprüche 1 bis 5,
wobei das Tempern ein Bestrahlen mittels Laserlichts (18) mit einer Wellenlänge von weniger als 400 nm aufweist.

7. Verfahren gemäß einem der Ansprüche 1 bis 6,
wobei das Tempern ein Bestrahlen mittels Laserlichts (18) mit einer Energiedichte von mehr als 2 J cm⁻² und weniger als 5 J cm⁻² aufweist.

8. Verfahren zum Bilden einer Halbleitervorrichtung (400), aufweisend
• Bilden eines Halbleiterbauelements (11), optional eines Transistors, in einem Siliziumcarbidsubstrat (310), aufweisend:
o Bilden einer Elektrode (16) des Halbleiterbauelements (11) mittels des Verfahrens zum Bilden eines elektrischen Kontakts gemäß einem der Ansprüche 1 bis 7 (320).

9. Verfahren gemäß einem der Ansprüche 1 bis 8,
wobei das Verfahren auf Waferebene ausgeführt wird.

## Claims

1. Method for forming an electrical contact (16), comprising:
• grinding a silicon carbide surface (101) using a grinding plate having an abrasive surface containing nickel or a nickel compound, in such a way that particles (12) of the nickel or nickel compound from the grinding plate are embedded in the ground silicon carbide surface (210); and
• annealing the ground silicon carbide surface (101g) by means of a laser, in such a way that at least some of the embedded nickel particles (12) form a nickel silicide with silicon from the silicon carbide (220).

2. Method according to Claim 1,
wherein the nickel silicide forms a surface layer (101gt) optionally having a mean roughness of 10 nm < Ra < 500 nm.

3. Method according to Claim 1 or 2,
wherein grinding the silicon carbide surface comprises thinning a silicon carbide substrate (10) to a thickness of between 50 um and 200 µm.

4. Method according to any of Claims 1 to 3,
wherein the ground silicon carbide surface (101g) has a mean roughness Ra of 10 nm < Ra < 500 nm.

5. Method according to any of Claims 1 to 4,
wherein the grinding plate contains between 0.1% by weight and 100% by weight of nickel.

6. Method according to any of Claims 1 to 5,
wherein the annealing comprises irradiating by means of laser light (18) having a wavelength of less than 400 nm.

7. Method according to any of Claims 1 to 6,
wherein the annealing comprises irradiating by means of laser light (18) having an energy density of more than 2 J cm⁻² and less than 5 J cm⁻².

8. Method for forming a semiconductor device (400), comprising
• forming a semiconductor component (11), optionally a transistor, in a silicon carbide substrate (310), comprising:
• forming an electrode (16) of the semiconductor component (11) by means of the method for forming an electrical contact according to any of Claims 1 to 7 (320) .

9. Method according to any of Claims 1 to 8,
wherein the method is carried out at the wafer level.

## Revendications

1. Procédé de formation d'un contact électrique (16), comprenant :
• le meulage d'une surface de carbure de silicium (101) avec un tampon de ponçage, qui présente une surface abrasive contenant du nickel ou un composé de nickel, de telle sorte que des particules (12) du nickel ou du composé de nickel provenant du tampon de ponçage soient incorporées (210) dans la surface de carbure de silicium meulée ; et
• le recuit de la surface de carbure de silicium meulée (101g) au moyen d'un laser, de telle sorte qu'au moins une partie des particules de nickel (12) incorporées forme un siliciure de nickel avec le silicium du carbure de silicium (220).

2. Procédé selon la revendication 1,
dans lequel le siliciure de nickel forme une couche superficielle (101gt) présentant facultativement une rugosité moyenne de 10 nm < Ra < 500 nm.

3. Procédé selon la revendication 1 ou 2,
dans lequel le meulage de la surface de carbure de silicium présente un amincissement d'un substrat de carbure de silicium (10) à une épaisseur comprise entre 50 µm et 200 µm.

4. Procédé selon l'une quelconque des revendications 1 à 3,
dans lequel la surface de carbure de silicium meulée (101g) présente une rugosité moyenne Ra de 10 nm < Ra < 500 nm.

5. Procédé selon l'une quelconque des revendications 1 à 4,
dans lequel le tampon de ponçage contient entre 0,1 % et 100 % en poids de nickel.

6. Procédé selon l'une quelconque des revendications 1 à 5,
dans lequel le recuit comporte une irradiation au moyen d'une lumière laser (18) ayant une longueur d'onde inférieure à 400 nm.

7. Procédé selon l'une quelconque des revendications 1 à 6,
dans lequel le recuit comprend une irradiation au moyen d'une lumière laser (18) ayant une densité d'énergie supérieure à 2 J cm⁻² et inférieure à 5 J cm⁻².

8. Procédé de formation d'un dispositif à semi-conducteurs (400), comprenant
• la formation d'un dispositif à semi-conducteurs (11), facultativement d'un transistor, dans un substrat de carbure de silicium (310), comprenant :
• la formation d'une électrode (16) du dispositif à semi-conducteurs (11) par le procédé de formation d'un contact électrique selon l'une quelconque des revendications 1 à 7 (320).

9. Procédé selon l'une quelconque des revendications 1 à 8,
dans lequel le procédé est mis en œuvre au niveau de la plaquette.
